# EUROPEAN PATENT APPLICATION

(11) **EP 3 404 716 A2**
(43) Date of publication of application: **21.11.2018**
(21) Application number: 18159252.8
(22) Date of filing: 28.02.2018
(51) Int. Cl.: H01L 27/146

(54) **SEMICONDUCTOR DEVICE AND METHOD FOR MANUFACTURING THE SAME**

(30) Priority: 27.04.2017 JP 2017087940
(71) Applicant: Renesas Electronics Corporation, 135-0061 Tokyo (JP)
(72) Inventor: TAKAHASHI, Fumitoshi, Hitachinaka-shi, Ibaraki 312-8504 (JP); KUNIKIYO, Tatsuya, Koutou-ku, Tokyo 135-0061 (JP); SATO, Hidenori, Hitachinaka-shi, Ibaraki 312-8504 (JP); GOTO, Yotaro, Hitachinaka-shi, Ibaraki 312-8504 (JP)
(74) Representative: Moore, Graeme Patrick

(57) **Abstract**

A semiconductor device which improves the dark current characteristics and transfer efficiency of a back-surface irradiation CMOS image sensor without an increase in the area of a semiconductor chip. In the CMOS image sensor, a pixel includes a transfer transistor (TT) and a photodiode (PD) with a pn junction. In plan view, a reflecting layer (RL) is formed over an n-type region (NR) which configures the photodiode, through an isolation insulating film (SO). The reflecting layer extends over the gate electrode (GE) of the transfer transistor through a cap insulating film (GSO). A first layer signal wiring (ML1) is electrically coupled to both the gate electrode and the reflecting layer through a contact hole (CN) made in an interlayer insulating film (IL) over the gate electrode, so the same potential is applied to the gate electrode and the reflecting layer.

## Description

### CROSS-REFERENCE TO RELATED APPLICATIONS

The disclosure of Japanese Patent Application No. 2017-087940 filed on April 27, 2017 including the specification, drawings and abstract is incorporated herein by reference in its entirety.

### BACKGROUND

The present invention relates to a semiconductor device and a method for manufacturing the same, and more particularly to technology useful for a semiconductor device with a solid-state imaging element which uses, for example, a back-surface irradiation CMOS (Complementary Metal Oxide Semiconductor) (hereinafter called a CMOS image sensor).

Japanese Unexamined Patent Application Publication (Translation of PCT Application) No. 2008-514011 describes a back-surface irradiation CMOS or CCD (Charge Coupled Device) imaging element which is manufactured using an SOI (Silicon on Insulator) wafer.

Japanese Unexamined Patent Application Publication No. 2009-16826 describes a back-surface irradiation image sensor which includes a photodiode formed under the front surface of a semiconductor substrate to generate photocharge by irradiation with light from the back surface of the semiconductor substrate, a reflecting gate formed above the photodiode over the front surface of the semiconductor substrate, and a transfer gate for transmitting the photocharge from the photodiode to a sensing node.

### SUMMARY

In the image sensor with a back-surface irradiation structure as disclosed in Japanese Unexamined Patent Application Publication No. 2009-16826, the reflecting gate is located just above the photodiode. In this structure, there are no restrictions on the wiring layout for the reflecting gate and the freedom in the wiring layout is high. However, since different potentials should be applied to the reflecting gate and the transfer gate, a special control circuit to apply a potential to the reflecting gate is required, thereby posing a problem that the area of the semiconductor chip should be increased.

The above and further objects and novel features of the invention will more fully appear from the following detailed description in this specification and the accompanying drawings.

According to one aspect of the invention, there is provided a semiconductor device which includes a transfer transistor and a photodiode which is adjacent to the transfer transistor and has a pn junction. The transfer transistor includes a gate insulating film formed on the main surface of a p-type semiconductor substrate; a gate electrode having a first surface in contact with the gate insulating film and a second surface opposite to the first surface; a sidewall spacer formed on each of both side faces of the gate electrode; a first n-type region provided in the semiconductor substrate on one side face side of the gate electrode; and a second n-type region provided in the semiconductor substrate on the other side face side of the gate electrode. The photodiode includes: a third n-type region which has a first depth from the main surface of the semiconductor substrate and is integrated with the first n-type region; a reflecting layer formed over the third n-type region and the second surface of the gate electrode in a manner to extend from the third n-type region to the second surface of the gate electrode in plan view; and an insulating film formed between the third n-type region and the reflecting layer. In an interlayer insulating film covering the gate electrode and the reflecting layer, a wiring is electrically coupled to both the gate electrode and the reflecting layer through a contact hole made over the second surface of the gate electrode and the same potential is applied to the gate electrode and the reflecting layer.

According to a second aspect of the invention, there is provided a method for manufacturing a semiconductor device which includes a transfer transistor and a photodiode which is adjacent to the transfer transistor and has a pn junction. First, a first n-type region which has a first depth from the main surface of a p-type semiconductor substrate and configures the photodiode is formed in the semiconductor substrate. Next, a laminated structure which includes a gate insulating film, a gate electrode, and a cap insulating film to configure the transfer transistor is formed in which the gate electrode has a first surface in contact with the gate insulating film and a second surface opposite to the first surface and the first n-type region is located in the semiconductor substrate on one side face side of the gate electrode. Next, an insulating film is deposited on the main surface side of the semiconductor substrate, the insulating film is processed to form a sidewall spacer on each of both side faces of the gate electrode, and an isolation insulating film is formed over the first n-type region. Next, a metal film or metal silicide film is deposited on the main surface side of the semiconductor substrate and the metal film or the metal silicide film is processed to form a reflecting layer extending from the isolation insulating film to the second surface of the gate electrode in plan view, over the isolation insulating film and the second surface of the gate electrode. Next, an interlayer insulating film is deposited on the main surface side of the semiconductor substrate, and the interlayer insulating film is processed to make a contact hole which reaches both the second surface of the gate electrode and the reflecting layer, over the second surface of the gate electrode and then, a plug is formed in the contact hole to couple the gate electrode and the reflecting layer electrically.

According to the present invention, the dark current characteristics and transfer efficiency of a back-surface irradiation CMOS image sensor can be improved without an increase in the area of a semiconductor chip.

### BRIEF DESCRIPTION OF THE DRAWINGS

Fig. 1 is an equivalent circuit for one pixel which configures the pixel section of a CMOS image sensor according to a first embodiment;
Fig. 2 is a sectional view of a main part of a pixel which configures the pixel section of the CMOS image sensor according to the first embodiment;
Fig. 3 is a sectional view which shows a main part of a pixel of the pixel section at a step in the process of manufacturing the CMOS image sensor according to the first embodiment;
Fig. 4 is a sectional view which shows a main part of a pixel at a step subsequent to the step of Fig. 3 in the process of manufacturing the CMOS image sensor;
Fig. 5 is a sectional view which shows a main part of a pixel at a step subsequent to the step of Fig. 4 in the process of manufacturing the CMOS image sensor;
Fig. 6 is a sectional view which shows a main part of a pixel at a step subsequent to the step of Fig. 5 in the process of manufacturing the CMOS image sensor;
Fig. 7 is a sectional view which shows a main part of a pixel at a step subsequent to the step of Fig. 6 in the process of manufacturing the CMOS image sensor;
Fig. 8 is a sectional view which shows a main part of a pixel at a step subsequent to the step of Fig. 7 in the process of manufacturing the CMOS image sensor;
Fig. 9 is a sectional view which shows a main part of a pixel at a step subsequent to the step of Fig. 8 in the process of manufacturing the CMOS image sensor;
Fig. 10 is a sectional view which shows a main part of a pixel at a step subsequent to the step of Fig. 9 in the process of manufacturing the CMOS image sensor;
Figs. 11A, 11B, and 11C are plan views of examples of a main part of a pixel which configures the pixel section of the CMOS image sensor according to the first embodiment, in which Fig. 11A shows a first example, Fig. 11B shows a second example, and Fig. 11C shows a third example;
Fig. 12 is a sectional view which shows a main part of a pixel at a step subsequent to the step of Fig. 10 in the process of manufacturing the CMOS image sensor;
Fig. 13 is a sectional view which shows a main part of a pixel at a step subsequent to the step of Fig. 12 in the process of manufacturing the CMOS image sensor;
Fig. 14 is a sectional view which shows a main part of a pixel at a step subsequent to the step of Fig. 13 in the process of manufacturing the CMOS image sensor;
Fig. 15 is a sectional view of a main part of a pixel which configures the pixel section of a CMOS image sensor according to a second embodiment;
Fig. 16 is a sectional view which shows a main part of a pixel of the pixel section at a step in the process of manufacturing the CMOS image sensor according to the second embodiment;
Fig. 17 is a sectional view which shows a main part of a pixel at a step subsequent to the step of Fig. 16 in the process of manufacturing the CMOS image sensor;
Fig. 18 is a sectional view which shows a main part of a pixel at a step subsequent to the step of Fig. 17 in the process of manufacturing the CMOS image sensor;
Fig. 19 is a sectional view which shows a main part of a pixel at a step subsequent to the step of Fig. 18 in the process of manufacturing the CMOS image sensor;
Fig. 20 is a sectional view which shows a main part of a pixel at a step subsequent to the step of Fig. 19 in the process of manufacturing the CMOS image sensor;
Fig. 21 is a plan view of a main part of the pixel section of a CMOS image sensor according to a third embodiment; and
Fig. 22 is a plan view which shows a main part of a pixel which configures the pixel section of the CMOS image sensor according to the third embodiment.

### DETAILED DESCRIPTION

The preferred embodiments of the present invention will be described below in different sections or separately as necessary or for the sake of convenience, but the embodiments described as such are not irrelevant to each other unless otherwise stated. One embodiment may be, in whole or in part, a modified, detailed or supplementary form of another.

Furthermore, in the preferred embodiments described below, when numerical information for an element (the number of pieces, numerical value, quantity, range, etc.) is given by a specific number, it is not limited to the specific number unless otherwise stated or theoretically limited to the specific number. It may be larger or smaller than the specific number.

In the preferred embodiments described below, obviously, constituent elements (including constituent steps) are not necessarily essential unless otherwise stated or considered theoretically essential.

Obviously, the expression "X comprising A", "X having A" or "X including A" does not exclude an element other than A unless it is expressly stated that A comprises, has, or includes only the element. Similarly, in the preferred embodiments described below, when a specific form or positional relation is indicated for an element, it should be interpreted to include a form or positional relation which is substantially approximate or similar to the specific form or positional relation unless otherwise stated or theoretically limited to the specific form or positional relation. The same is true for the above numerical information and range.

In all the drawings that illustrate the preferred embodiments, basically the same elements with the same functions are designated by the same reference signs and their description is not repeated. In sectional views, the size of each part may not be proportional to that in an actual device. For easy understanding, a specific part may be shown as disproportionally large.

Next, the preferred embodiments will be described in detail referring to drawings.

### First Embodiment

### «CMOS image sensor»

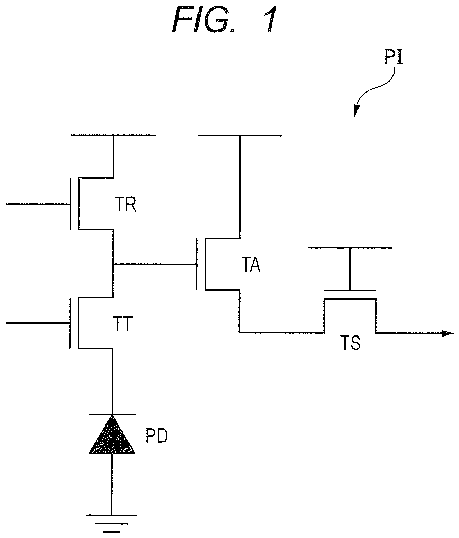

A CMOS image sensor according to the first embodiment is described below referring to Fig. 1. Fig. 1 is an equivalent circuit for one pixel which configures the pixel section of the CMOS image sensor according to the first embodiment.

As shown in Fig. 1, each pixel PI which configures the pixel section of the CMOS image sensor includes, for example, a photodiode PD which accumulates signal charge through photoelectric conversion, a transfer transistor TT which functions as a switch in transferring the signal charge, an amplifier transistor TA, a selection transistor TS, and a reset transistor TR. As light enters the pixel PI, it is photoelectrically converted and signal charge depending on the intensity of the light is accumulated in the photodiode PD. The transfer transistor TT is turned ON/OFF according to the pulse applied to the gate of the transfer transistor TT and the voltage component of the signal charge accumulated in the photodiode PD is transmitted to the outside through the amplifier transistor TA.

### «Structure of the pixel section of the CMOS image sensor»

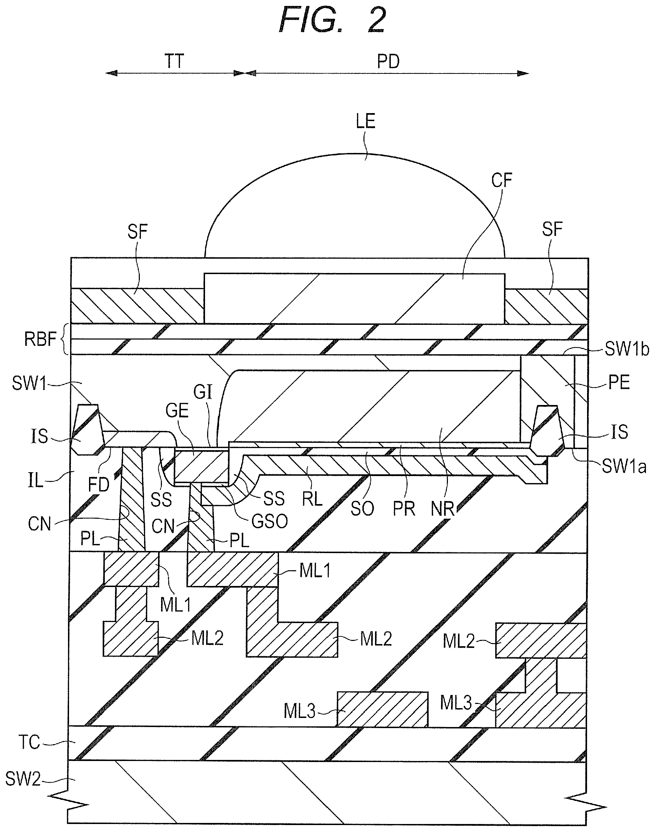

The structure of the pixel section of the back-surface irradiation CMOS image sensor according to the first embodiment is described below referring to Fig. 2. Fig. 2 is a sectional view of a main part of a pixel which configures the pixel section of the CMOS image sensor according to the first embodiment.

As shown in Fig. 1, each pixel PI which configures the pixel section of the CMOS image sensor includes a photodiode PD, transfer transistor TT, amplifier transistor TA, selection transistor TS, and reset transistor TR. In the explanation here, focus is placed only on the photodiode PD and transfer transistor TT.

An active region surrounded by an element isolation area IS is formed on the main surface (front surface, first main surface) SW1a of a semiconductor substrate (first substrate) SW1 made of p-type monocrystalline silicon. The thickness of the semiconductor substrate SW1 is, for example, about 2.5 µm to 3 µm.

An n-type region NR doped with n-type impurities is formed in the semiconductor substrate SW1, with a given depth from the main surface SW1a of the semiconductor substrate SW1 and the semiconductor substrate SW1 and the n-type region NR make up the pn junction of the photodiode PD. The depth of the n-type region NR from the main surface SW1a of the semiconductor substrate SW1 is, for example, about 2 µm and its impurity concentration is, for example, about 10¹² cm⁻³. It is also possible to form a p-type well in the semiconductor substrate SW1 so that the p-type well and the n-type region NR make up the pn junction of the photodiode PD.

In order to prevent a depletion layer from spreading to the element isolation area IS, a pixel isolation region PE doped with p-type impurities is formed in the semiconductor substrate SW1's area around the element isolation area IS which defines the photodiode PD formation area. The depth of the pixel isolation region PE from the main surface SW1a of the semiconductor substrate SW1 is, for example, about 2.5 µm to 3 µm and its impurity concentration is, for example, about 10¹² cm⁻³ to 10¹³ cm⁻³.

In order to improve the dark current in the main surface SW1a of the semiconductor substrate SW1, a p-type region PR doped with p-type impurities is formed in the n-type region NR, with a given depth from the main surface SW1a of the semiconductor substrate SW1. The depth of the p-type region PR from the main surface SW1a of the semiconductor substrate SW1 is, for example, about 5 nm and its impurity concentration is, for example, about 10¹³ cm⁻³. The p-type region PR is omissible.

Furthermore, a reflecting layer RL is formed over the main surface SW1a of the semiconductor substrate SW1 through an isolation insulating film SO in a manner to overlap the n-type region NR in plan view. Due to the presence of the reflecting layer RL, incoming light is reflected by the reflecting layer RL and captured by the photodiode PD, so light loss can be reduced, leading to improvement in sensitivity. The isolation insulating film SO is, for example, made of silicon oxide. The reflecting layer RL is made of a material which is electrically conductive and excellent in light reflection, such as a metal or metal silicide. An example of such metal is tungsten. An example of such metal silicide is cobalt silicide or nickel silicide.

A transfer transistor TT is formed on the main surface SW1a of the semiconductor substrate SW1. The transfer transistor TT includes: a gate insulating film GI formed over the main surface SW1a of the semiconductor substrate SW1; a gate electrode GE formed over the gate insulating film GI; a sidewall spacer SS formed on each of both side faces of the gate electrode GE; and a pair of n-type regions formed in the semiconductor substrate SW1 on both sides of the sidewall spacers SS. One of the paired n-type regions is integrated with the n-type region NR of the photodiode PD and the other n-type region functions as a floating diffusion layer FD. Furthermore, a cap insulating film GSO is formed on the surface of the gate electrode GE which is opposite to its surface in contact with the gate insulating film GI.

The gate insulating film GI is, for example, made of silicon oxide and its thickness is, for example, about 7 nm to 8 nm. The gate electrode GE is, for example, made of polycrystalline silicon and its thickness is, for example, 50 nm to 150 nm. The depth of the floating diffusion layer FD from the main surface SW1a of the semiconductor substrate SW1 is, for example, about 0.5 µm to 1 µm and its impurity concentration is, for example, about 10¹⁴ cm⁻³ to 10¹⁵ cm⁻³. The cap insulating film GSO is, for example, made of silicon oxide and its thickness is, for example, about 10 nm to 20 nm.

The gate electrode GE has a surface in contact with the gate insulating film GI and a surface opposite to the surface in contact with the gate insulating film GI (surface in contact with the cap insulating film GSO). In the explanation below, the surface in contact with the gate insulating film GI will be called the first surface and the surface opposite to the surface in contact with the gate insulating film GI (surface in contact with the cap insulating film GSO) will be called the second surface.

The gate electrode GE of the transfer transistor TT functions as a pixel selection switch. When a positive potential is applied to the selected gate electrode GE, the charge accumulated in the photodiode PD is transferred to the floating diffusion layer FD.

The reflecting layer RL lies not only over the n-type region NR but also over part of the second surface of the gate electrode GE, so in plan view the reflecting layer RL extends from the n-type region NR to the second surface of the gate electrode GE. Specifically, in plan view the reflecting layer RL includes a portion overlapping the n-type region NR, a portion overlapping one of the sidewall spacers SS, and a portion overlapping part of the second surface of the gate electrode GE. The isolation insulating film SO lies between the reflecting layer RL and the n-type region NR and the cap insulating film GSO lies between the reflecting layer RL and the gate electrode GE.

In the first embodiment, the reflecting layer RL is formed over the second surface of the gate electrode GE of the transfer transistor TT through the cap insulating film GSO. However, instead, the reflecting layer RL may be formed without the cap insulating film GSO. In other words, the cap insulating film GSO may or may not be formed between the second surface of the gate electrode GE of the transfer transistor TT and the reflecting layer RL. However, if the polycrystalline silicon of the gate electrode GE directly contacts the metal of the reflecting layer RL, for example, tungsten, there is a possibility that reaction between the polycrystalline silicon and tungsten may produce a compound of silicon and tungsten. If a compound of silicon and tungsten is produced on the second surface of the gate electrode GE, the resistance of the gate electrode GE would fluctuate and the potential applied to the gate electrode GE for each pixel would change at the time of reading, resulting in deterioration in image quality. For this reason, it is desirable to provide a cap insulating film GSO between the second surface of the gate electrode GE of the transfer transistor TT and the reflecting layer RL.

A first layer signal wiring ML1, a second layer signal wiring ML2, and a third layer signal wiring ML3 which are made of metal and electrically coupled to the gate electrode GE or floating diffusion layer FD of the transfer transistor TT are formed on the main surface SW1a side of the semiconductor substrate SW1. The first layer signal wiring ML1, second layer signal wiring ML2, and third layer signal wiring ML3 are wirings which contribute to operation of each pixel.

The first layer signal wiring ML1 is concretely described below. An interlayer insulating film IL is formed over the main surface SW1a of the semiconductor substrate SW1 in a manner to cover the transfer transistor TT and the reflecting layer RL. The first layer signal wiring ML1 is electrically coupled to the gate electrode GE or floating diffusion layer FD of the transfer transistor TT through a plug PL penetrating the interlayer insulating film IL. The plug PL is formed inside a contact hole CN made in the interlayer insulating film IL and its main conductive material is a metal such as tungsten combined with a barrier metal. The barrier metal is intended to prevent diffusion of metal as the main conductive material of the plug PL and for example, it is titanium or titanium nitride.

The contact hole CN is made over the second surface of the gate electrode GE so as to reach both the second surface of the gate electrode GE and the reflecting layer RL lying over the second surface of the gate electrode GE. In other words, the contact hole CN is made over the second surface of the gate electrode GE in a manner to stride across the gate electrode GE and the reflecting layer RL in plan view. Consequently, the plug PL electrically coupled to the gate electrode GE of the transfer transistor TT is also electrically coupled to the reflecting layer RL lying over the second surface of the gate electrode GE and thus the same potential can be applied to the gate electrode GE of the transfer transistor TT and the reflecting layer RL.

For transfer of charge, as a positive potential is applied to the gate electrode GE of the transfer transistor TT in order to make the transfer transistor TT conductive, the positive potential is also applied to the reflecting layer RL. As the positive potential is applied to the reflecting layer RL, the positive potential is applied to a wide area of the photodiode PD in the planar direction and thus failure to capture the charge is reduced, leading to improvement in transfer efficiency.

For accumulation of charge, as a negative potential is applied to the gate electrode GE of the transfer transistor TT in order to shut off the transfer transistor TT, the negative potential is also applied to the reflecting layer RL. As the negative potential is applied to the reflecting layer RL, hole induction is accelerated in the photodiode PD on the main surface SW1a side of the semiconductor substrate SW1, which makes it possible to suppress minute leak currents attributable to electrons/holes generated due to a crystal fault, etc. and thus reduces dark current.

In addition, since it is unnecessary to provide a special control circuit to apply a potential to the reflecting layer RL, the need to increase the area of the semiconductor chip where the CMOS image sensor is mounted is suppressed.

Furthermore, a protective insulating film TC which covers the third layer signal wiring ML3 as the uppermost layer wiring is formed. In the first embodiment, the multi-layer wiring structure which includes three layers of wirings is given as an example, but the wiring structure is not limited to it; instead, a multi-layer wiring structure which includes two layers of wirings or four or more layers of wirings may be adopted.

A support substrate (second substrate) SW2 is attached to the surface (junction surface) of the protective insulating film TC which covers the third layer signal wiring ML3 as the uppermost layer wiring so that the whole CMOS image sensor is supported by the support substrate SW2. The thickness of the support substrate SW2 is, for example, about 735 µm.

An antireflection film RBF is formed on the back surface (second main surface) SW1b of the semiconductor substrate SW1 opposite to the main surface SW1a and a color filter CF and a micro-lens LE are placed over the antireflection film RBF. The antireflection film RBF is, for example, a laminated film which includes a high-permittivity film and oxide film. Moreover, a light shielding film SF is formed over the area of the antiref lection film RBF where the color filter CF and micro-lens LE are not placed. The light shielding film SF is, for example, made of metal such as tungsten.

### «Method for manufacturing the CMOS image sensor»

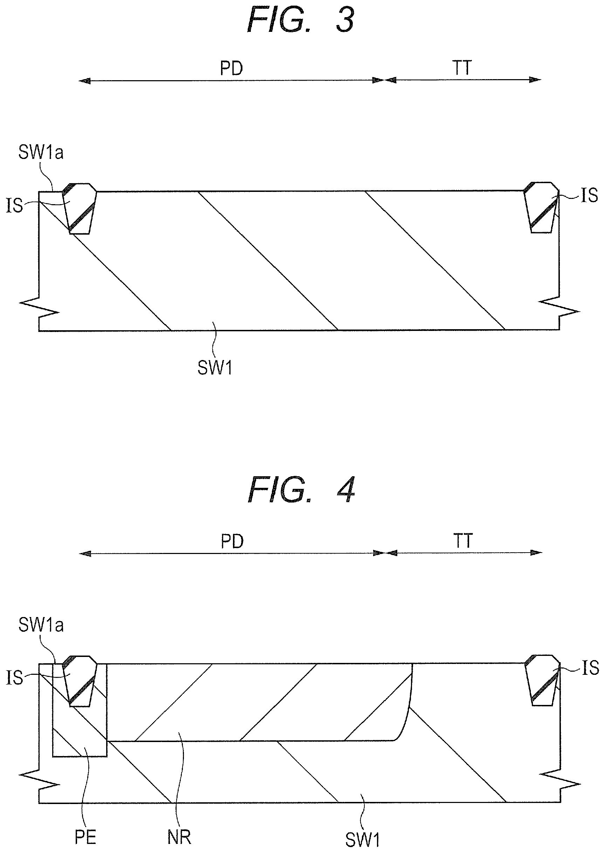

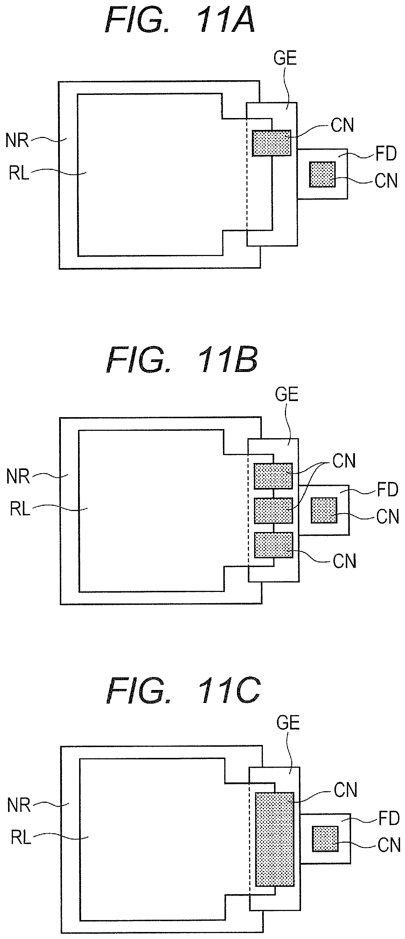

Next, the method for manufacturing the back-surface irradiation CMOS image sensor according to the first embodiment will be described in a step-by-step sequence, referring to Figs. 3 to 14. Figs. 3 to 10 and Figs. 12 to 14 are sectional views which show a main part of a pixel of the pixel section during the process of manufacturing the CMOS image sensor according to the first embodiment. Figs. 11A, 11B, and 11C are plan views which show the first, second, and third examples of a main part of a pixel of the pixel section of the CMOS image sensor, respectively.

As shown in Fig. 1, each pixel PI of the pixel section of the CMOS image sensor includes a photodiode PD, transfer transistor TT, amplifier transistor TA, selection transistor TS, and reset transistor TR. In the explanation here, focus is placed only on the photodiode PD and transfer transistor TT.

The pixel section (one pixel) of the CMOS image sensor can be manufactured, for example, as follows.

First, as shown in Fig. 3, for example, a semiconductor substrate of p-type monocrystalline silicon (semiconductor wafer in the shape of a circular thin plate) SW1 is provided. The thickness of the semiconductor substrate SW1 is, for example, about 735 µm. Then, a trench is made in an element isolation region of the main surface SW1a of the semiconductor substrate SW1 and after that, an element isolation area IS is formed by burying insulating film in the trench.

Next, as shown in Fig. 4, in order to prevent a depletion layer from spreading to the element isolation area IS, a pixel isolation region PE is formed in the semiconductor substrate SW1's area around the element isolation area IS which defines the photodiode PD formation region, by implanting p-type impurity ions from the main surface SW1a side of the semiconductor substrate SW1. For example, boron ions as p-type impurities are implanted in the pixel isolation region PE. The depth of the pixel isolation region PE from the main surface SW1a of the semiconductor substrate SW1 is, for example, about 2.5 µm to 3 µm and the impurity concentration of the pixel isolation region PE is, for example, about 10¹² cm⁻³ to 10¹³ cm⁻³.

Next, an n-type region NR is formed in the semiconductor substrate SW1 in the photodiode PD formation region by implanting n-type impurity ions from the main surface SW1a side of the semiconductor substrate SW1. For example, phosphorous or arsenic ions as n-type impurities are implanted in the n-type region NR. The depth of the n-type region NR from the main surface SW1a of the semiconductor substrate SW1 is, for example, about 2 µm and the impurity concentration of the n-type region NR is, for example, about 10¹² cm⁻³.

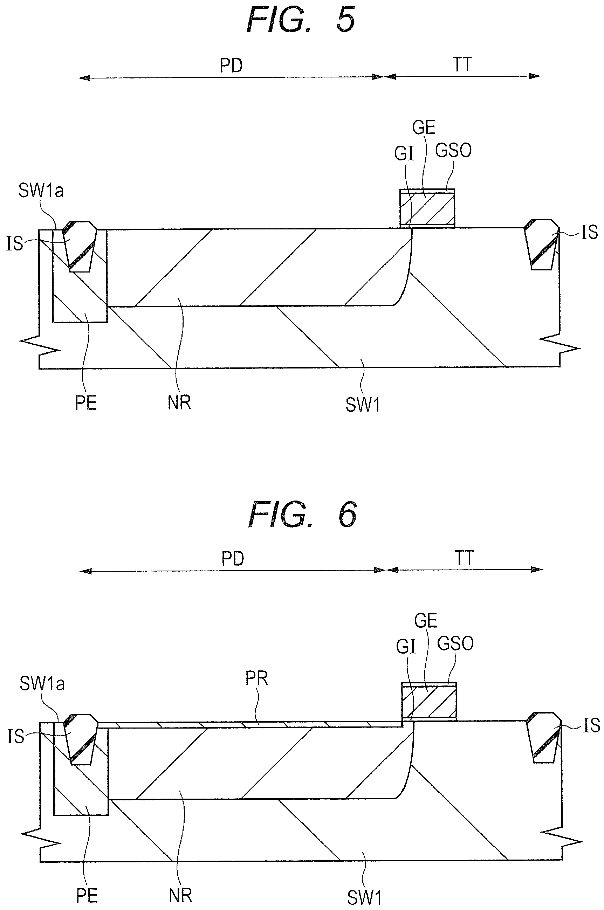

Next, as shown in Fig. 5, an insulating film such as a silicon oxide film is formed on the main surface SW1a of the semiconductor substrate SW1 by the RTA (Rapid Thermal Annealing) method. Then, over the insulating film, a conductor film such as a polycrystalline silicon film, and an insulating film such as a silicon oxide film are sequentially deposited, for example, by the CVD (Chemical Vapor Deposition) method. The thickness of the lower insulating film is, for example, about 7 nm to 8 nm, the thickness of the conductor film is, for example, about 150 nm, and the thickness of the upper insulating film is, for example, about 10 nm to 20 nm.

Next, the upper insulating film, conductor film and lower insulating film are sequentially processed by etching using a resist pattern as a mask to form a cap insulating film GSO from the upper insulating film, form a gate electrode GE of the transfer transistor TT from the conductor film, and form a gate insulating film GI of the transfer transistor TT from the lower insulating film. Then, the resist pattern is removed.

Since the gate electrode GE of the transfer transistor TT is intended to transfer the electrons accumulated in the n-type region NR, the gate electrode of the transfer transistor TT is formed so that the n-type region NR is located on one side face side of the gate electrode GE in plan view.

Alternatively, the gate electrode GE may be formed as a laminated film in which a polycrystalline silicon film and a silicide film are deposited sequentially from under or as a laminated film in which a polycrystalline silicon film and a metal film are deposited sequentially from under.

Next, as shown in Fig. 6, in order to improve the dark current in the main surface SW1a of the semiconductor substrate SW1, a p-type region PR is formed on the surface of the n-type region NR in the photodiode PD formation region, by implanting p-type impurity ions from the main surface SW1a side of the semiconductor substrate SW1. For example, boron ions or boron fluoride ions as p-type impurities are implanted in the p-type region PR. The depth of the p-type region PR from the main surface SW1a of the semiconductor substrate SW1 is, for example, about 5 nm and the impurity concentration of the p-type region PR is, for example, about 10¹³ cm⁻³.

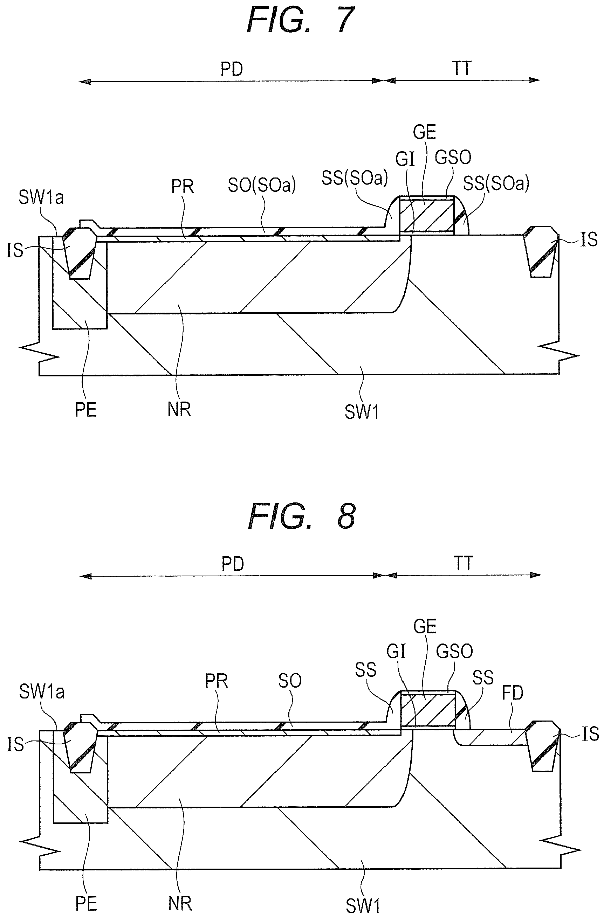

Next, as shown in Fig. 7, an insulating film SOa is formed over the main surface SW1a of the semiconductor substrate SW1. The insulating film SOa is, for example, made of silicon oxide and its thickness is about 50 nm to 20 nm.

Next, a resist pattern is made in the photodiode PD formation region, and then the insulating film SOa is anisotropically etched, for example, by the RIE (Reactive Ion Etching) method. By doing so, a sidewall spacer SS is formed from the insulating film SOa on each of both side faces of the gate electrode GE of the transfer transistor TT and an isolation insulating film SO is formed from the insulating film SOa over the main surface SW1a of the semiconductor substrate SW1 in the photodiode PD formation region. Then, the resist pattern is removed.

Next, as shown in Fig. 8, a floating diffusion layer FD is formed in the semiconductor substrate SW1 on the other side face side of the gate electrode GE of the transfer transistor TT (opposite to the n-type region NR across a channel region) by implanting n-type impurity ions from the main surface SW1a side of the semiconductor substrate SW1. The floating diffusion layer FD serves as a capacitative element for conversion of electrons accumulated in the photodiode PD into a voltage. For example, phosphorous ions or arsenic ions as n-type impurities are implanted in the floating diffusion region FD. The depth of the floating diffusion region FD from the main surface SW1a of the semiconductor substrate SW1 is, for example, about 0.5 µm to 1 µm and the impurity concentration of the floating diffusion layer FD is, for example, about 10¹⁴ cm⁻³ to 10¹⁵ cm⁻³.

In plan view, the floating diffusion layer FD is formed so as to be located on the other side face side of the gate electrode GE of the transfer transistor TT. Consequently, the n-type region NR, which configures the photodiode PD, is formed on one side of the semiconductor substrate SW1 and the floating diffusion layer FD is formed on the other side of the semiconductor substrate SW1 with the gate electrode GE of the transfer transistor TT between them.

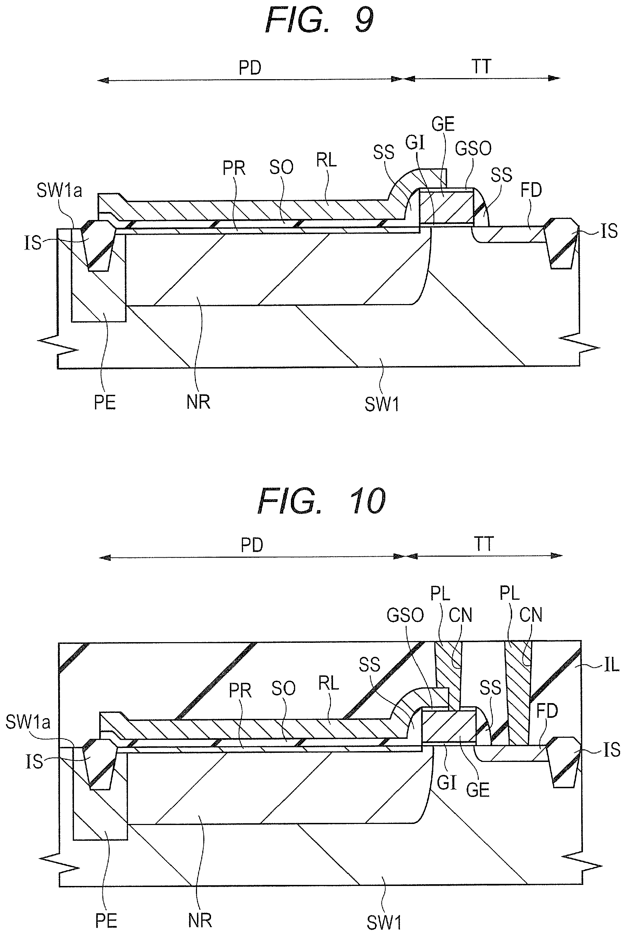

Next, as shown in Fig. 9, a metal film such as a tungsten film is deposited over the main surface SW1a of the semiconductor substrate SW1, for example, by the sputtering method. Then, a reflecting layer RL of metal is formed over the isolation insulating film SO and over the second surface of the gate electrode GE of the transfer transistor TT by etching the metal film using a resist pattern as a mask so that the metal film remains in the area from the isolation insulating film SO to the second surface of the gate electrode GE in plan view. At this time, the reflecting layer RL is formed in a manner to cover part of the second surface of the gate electrode GE in plan view. Then, the resist pattern is removed.

The reflecting layer RL is not limited to a metal film; instead, it may be formed as a metal silicide film, such as a cobalt silicide film or nickel silicide film.

Although the reflecting layer RL is formed over the second surface of the gate electrode GE of the transfer transistor TT through the cap insulating film GSO, instead the reflecting layer RL may be formed without the cap insulating film GSO. In other words, the cap insulating film GSO may or may not be formed between the second surface of the gate electrode GE of the transfer transistor TT and the reflecting layer RL. However, if the polycrystalline silicon of the gate electrode GE directly contacts the tungsten of the reflecting layer RL, there is a possibility that reaction between the silicon and tungsten may produce a compound of silicon and tungsten. If a compound of silicon and tungsten is produced on the second surface of the gate electrode GE, the resistance of the gate electrode GE would fluctuate and the potential applied to the gate electrode GE for each pixel would change at the time of reading, resulting in deterioration in image quality. For this reason, it is desirable to provide a cap insulating film GSO between the second surface of the gate electrode GE of the transfer transistor TT and the reflecting layer RL.

Next, as shown in Fig. 10, an interlayer insulating film IL, for example, made of silicon oxide is deposited over the main surface SW1a of the semiconductor substrate SW1 and then the surface of the interlayer insulating film IL is polished, for example, by the CMP (Chemical Mechanical Polishing) method to planarize it.

Next, a contact hole CN is made in the interlayer insulating film IL by etching using a resist pattern as a mask. The contact hole CN is made so as to reach the floating diffusion layer FD or the gate electrode GE. Then, the resist pattern is removed.

The contact hole CN is made over the second surface of the gate electrode GE of the transfer transistor TT so as to reach both the second surface of the gate electrode GE and the reflecting layer RL lying over the second surface of the gate electrode GE. In other words, the contact hole CN made over the second surface of the gate electrode GE strides across the gate electrode GE and the reflecting layer RL in plan view.

The contact hole CN made over the second surface of the gate electrode GE of the transfer transistor TT has only to reach both the gate electrode GE and the reflecting layer RL and such contact holes can be made in various patterns in plan view. For example, a contact hole CN may be made as shown in Fig. 11A, in which the dimension in the gate width direction is smaller than the dimension in the gate length direction. Alternatively, a plurality of contact holes CN may be made as shown in Fig. 11B, in which the dimension in the gate width direction is smaller than the dimension in the gate length direction. Alternatively, one long contact hole CN may be made as shown in Fig. 11C, in which the dimension in the gate width direction is larger than the dimension in the gate length direction.

Next, a plug PL which uses a metal such as tungsten combined with a barrier metal as its main conductive material is formed inside a contact hole CN. The barrier metal is intended to prevent diffusion of the metal as the main conductive material of the plug PL and for example, it is titanium or titanium nitride.

Since the contact hole CN made over the second surface of the gate electrode GE of the transfer transistor TT also reaches the reflecting layer RL, the plug PL is formed in a manner to stride across the gate electrode GE and the reflecting layer RL.

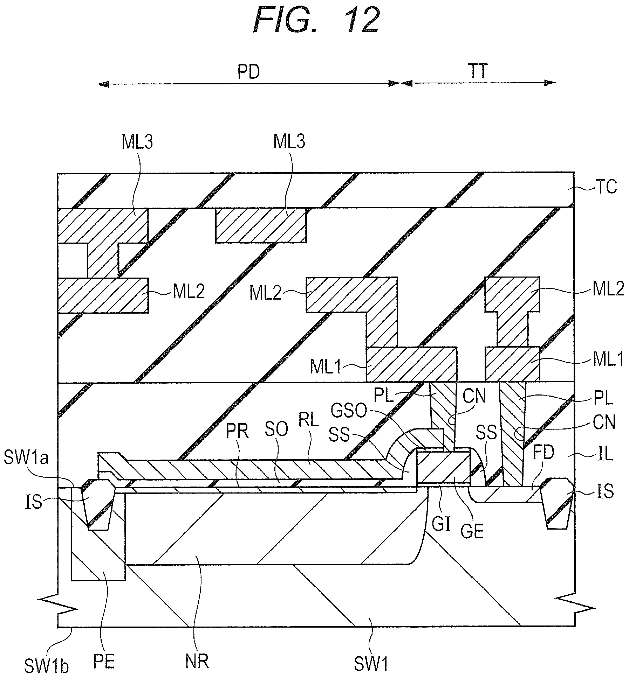

Next, as shown in Fig. 12, a first layer signal wiring ML1 to be electrically coupled to a plug PL is formed, for example, by the Single Damascene method. A first layer signal wiring ML1 is, for example, made of copper.

A first layer signal wiring ML1 is electrically coupled to the floating diffusion layer FD through a plug PL and another first layer signal wiring ML1 is electrically coupled to both the gate electrode GE of the transfer transistor TT and the reflecting layer RL through a plug PL striding across the gate electrode GE and the reflecting layer RL.

Furthermore, a second layer signal wiring ML2 to be electrically coupledto a first layer signal wiring ML1 is formed, for example, by the Dual Damascene method. A second layer signal wiring ML2 is, for example, made of copper. Furthermore, a third layer signal wiring ML3 to be electrically coupled to a second layer signal wiring ML2 is formed, for example, by the Dual Damascene method. A third layer signal wiring ML3 is, for example, made of copper.

Although different layers of signal wirings ML1, ML2 and ML3 are formed by the Damascene method in this embodiment, the method for forming signal wirings is not limited to the Damascene method. For example, signal wirings may be formed by processing a metal film such as an aluminum alloy film using the lithographic technique or etching technique.

Next, a protective insulating film TC is deposited over the main surface SW1a of the semiconductor substrate SW1 in a manner to cover the third layer signal wirings ML3 and then the surface of the protective insulating film TC is planarized by polishing the film, for example, by the CMP method.

Next, in order to prevent chipping of the periphery of the semiconductor substrate SW1 during grinding of the back surface SW1b of the semiconductor substrate SW1 (later step), the periphery of the semiconductor substrate SW1 is trimmed. Instead, this trimming work may be carried out after the attaching step (later step), but in order to avoid metallic contamination which might be caused by the blade of the trimming device, it is desirable to carry out the trimming work before the attaching step.

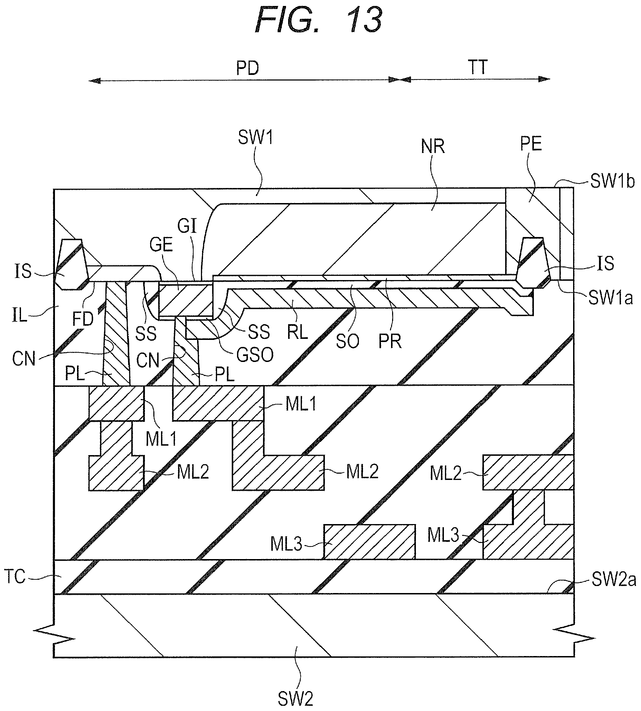

Next, as shown in Fig. 13, a support substrate SW2, for example, made of monocrystalline silicon (semiconductor wafer in the shape of a circular thin plate) is provided. The thickness of the support substrate SW2 is, for example, about 735 µm. Next, the front surface SW2a of the support substrate SW2 is plasma-activated in a nitrogen atmosphere and then washed with water. Similarly, the surface of the protective insulating film TC formed over the main surface SW1a of the semiconductor substrate SW1 is plasma-activated in a nitrogen atmosphere and then washed with water.

Next, the semiconductor substrate SW1 and the support substrate SW2 are put one upon the other in a manner that the front surface of the plasma-activated protective insulating film TC and the front surface SW2a of the plasma-activated support substrate SW2 face each other. Consequently, the front surface of the protective insulating film TC and the front surface SW2a of the support substrate SW2 are spontaneously joined.

Next, the front surface of the protective insulating film TC and the front surface SW2a of the support substrate SW2 are permanently joined by heat treatment, for example, at 200°C to 300°C or so in an ambient air atmosphere. As a result of this heat treatment, oxygen (O) molecules and hydrogen (H) molecules which are terminated on the front surface of the protective insulating film TC and the front surface SW2a of the support substrate SW2 are combined into H₂O and desorbed to produce a silicon-silicon bond.

Next, the thickness of the semiconductor substrate SW1 is decreased by grinding its back surface SW1b. First, the thickness of the semiconductor substrate SW1 is decreased, for example, to 50 µm or less by pressing a grinding material (for example, diamond grindstone) with a first roughness against the back surface SW1b of the semiconductor substrate SW1 and grinding it roughly. Then, finish grinding is done on the back surface SW1b of the semiconductor substrate SW1 by pressing a grinding material with a second roughness higher in fineness than the first roughness against it, in order to eliminate warping of the back surface SW1b of the semiconductor substrate SW1 which has occurred during rough grinding. Then, the back surface SW1b of the semiconductor substrate SW1 is polished by the CMP method.

Next, the back surface SW1b of the semiconductor substrate SW1 is etched by the wet etching method to make the thickness of the semiconductor substrate SW1, for example, about 2.5 µm to 3 µm.

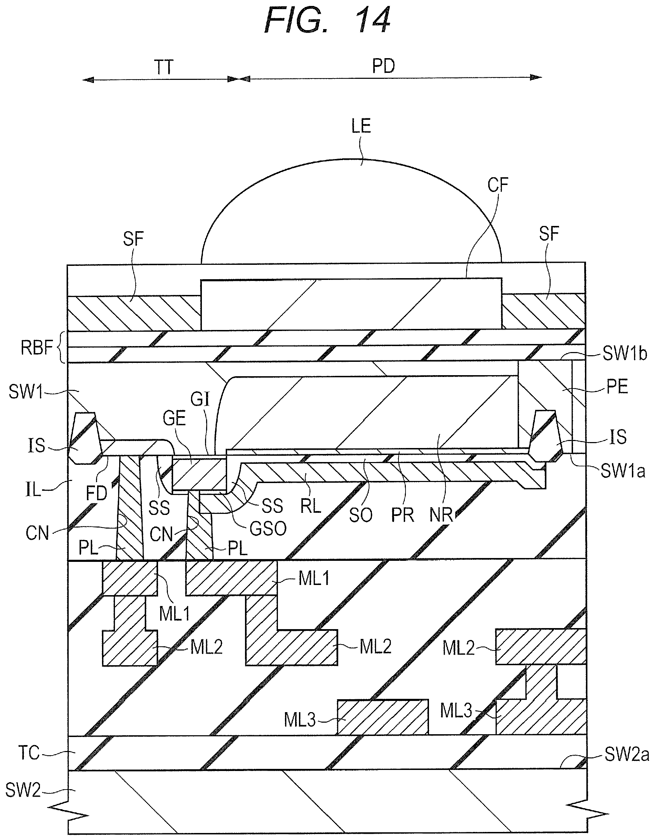

Next, as shown in Fig. 14, an antireflection film RBF and a light shielding film SF are sequentially deposited on the back surface SW1b of the semiconductor substrate SW1 and the unrequired portion of the light shielding film SF in the pixel section is removed. The antireflection filmRBF is, for example, a laminated film which includes, for example, a high-permittivity film and an oxide film and the light shielding film SF is made of metal such as tungsten.

Next, a color filter CF is made over the antireflection film RBF' s portion in the pixel section where the light shielding film SF does not lie, and a micro-lens LE is made over the color filter CF.

With the above steps, the pixel section of the CMOS image sensor is almost completed.

After that, the semiconductor substrate SW1 with the support substrate SW2 attached is vertically and horizontally cut along cutting areas into individual semiconductor chips.

As described so far, according to the first embodiment, in plan view, the reflecting layer RL is formed in a manner to extend from the n-type region NR of the photodiode PD to part of the second surface of the gate electrode GE of the transfer transistor TT and a plug PL striding across the gate electrode GE and the reflecting layer RL is formed over the second surface of the gate electrode GE so that the same potential can be applied to the gate electrode GE and the reflecting layer RL.

Consequently, as mentioned above, for transfer of charge, when a positive potential is applied to the gate electrode GE of the transfer transistor TT, the positive potential is also applied to the reflecting layer RL and thus failure to capture the charge is reduced, leading to improvement in transfer efficiency. Moreover, for accumulation of charge, as a negative potential is applied to the gate electrode GE of the transfer transistor TT, the negative potential is also applied to the reflecting layer RL, so dark current can be reduced. Furthermore, it is unnecessary to provide a special control circuit to apply a potential to the reflecting layer RL, so the need to increase the area of the semiconductor chip where the CMOS image sensor is mounted is suppressed.

### Second Embodiment

### «Structure of the pixel section of the CMOS image sensor»

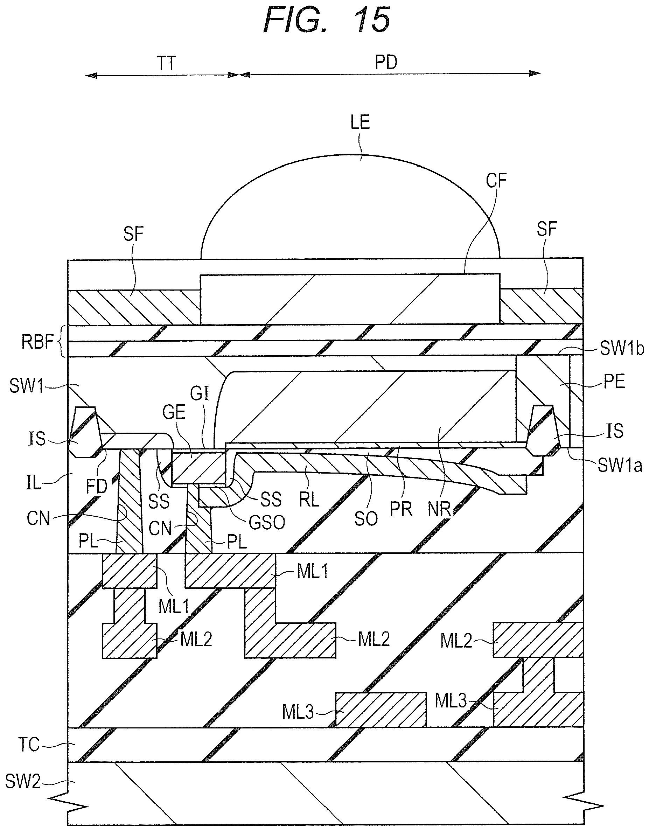

The structure of the pixel section of the back-surface irradiation CMOS image sensor according to the second embodiment will be described referring to Fig. 15. Fig. 15 is a sectional view of a main part of a pixel which configures the pixel section of the CMOS image sensor according to the second embodiment.

As shown in Fig. 15, the pixel section of the CMOS image sensor according to the second embodiment is different from the pixel section of the CMOS image sensor according to the first embodiment in the thickness of the isolation insulating film SO formed between the n-type region NR and the reflecting layer RL in the photodiode PD formation region. Whereas in the first embodiment the thickness of the isolation insulating film SO in the photodiode PD formation region is almost constant, in the second embodiment the thickness of the isolation insulating film SO in the photodiode PD formation region gradually decreases toward the gate electrode GE of the transfer transistor TT.

For transfer of charge, as a positive potential is applied to the gate electrode GE of the transfer transistor TT in order to make the transfer transistor TT conductive, the positive potential is also applied to the reflecting layer RL. As the positive potential is applied to the reflecting layer RL, the positive potential is applied to a wide area of the photodiode PD in the planar direction. Since the thickness of the isolation insulating film SO gradually decreases toward the gate electrode GE of the transfer transistor TT, the potential applied to the n-type region NR gradually increases, thereby producing a gradient of potential. Consequently, the CMOS image sensor according to the second embodiment is less likely to fail to capture the charge and provides higher transfer efficiency than the CMOS image sensor according to the first embodiment.

### «Method for manufacturing the CMOS image sensor»

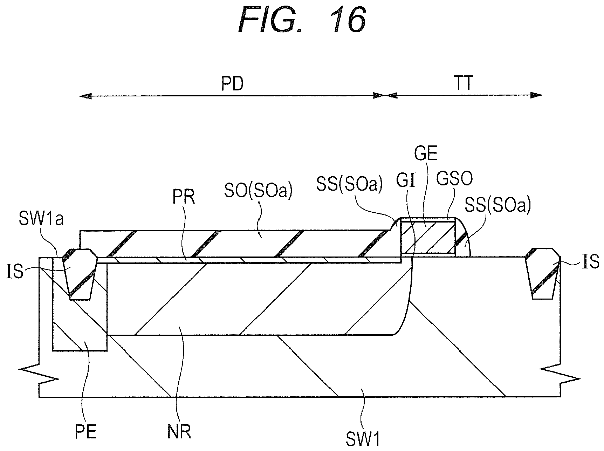

Next, the method for manufacturing the back-surface irradiation CMOS image sensor according to the second embodiment will be described, referring to Figs. 16 to 20. Figs. 16 to 20 are sectional views which show a main part of a pixel of the pixel section during the process of manufacturing the CMOS image sensor according to the second embodiment.

The pixel section of the CMOS image sensor according to the second embodiment is different from the pixel section of the CMOS image sensor according to the first embodiment in the structure of the isolation insulating film SO formed between the n-type region NR and the reflecting layer RL in the photodiode PD formation region. The other elements are the same as or substantially the same as the structure of the pixel section of the CMOS image sensor according to the first embodiment and their description is omitted here.

First, the pn junction of the photodiode PD and the gate electrode GE of the transfer transistor TT are formed as shown in Figs. 3 to 6 for the first embodiment.

Next, as shown in Fig. 16, an insulating film SOa is deposited over the main surface SW1a of the semiconductor substrate SW1. The insulating film SOa is, for example, made of silicon oxide and its thickness is, for example, about 200 nm.

Next, a resist pattern is made in the photodiode PD formation region, and then the insulating film SOa is anisotropically etched, for example, by the RIE method. By doing so, a sidewall spacer SS is formed from the insulating film SOa on each of both side faces of the gate electrode GE of the transfer transistor TT and an isolation insulating film SO is formed from the insulating film SOa over the main surface SW1a of the semiconductor substrate SW1 in the photodiode PD formation region. Then, the resist pattern is removed.

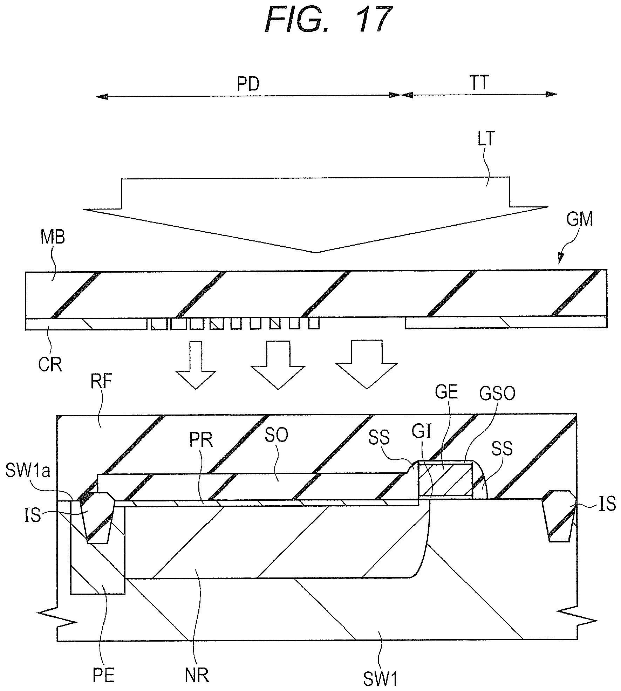

Next, as shown in Fig. 17, resist film RF is coated over the main surface SW1a of the semiconductor substrate SW1 and then the resist film RF is exposed and developed. In exposure, transmission of light radiated from a light source LT is controlled, using, for example, a gray scale mask GM in which a pattern CR of chrome is made on the surface of mask blanks (quartz plate) MB. Specifically, in the photodiode PD formation region, the quantity of light transmitted through the gray scale mask GM is increased in an area near the gate electrode GE of the transfer transistor TT and the quantity of light transmitted through the gray scale mask GM is gradually decreased as the distance to the gate electrode GE increases.

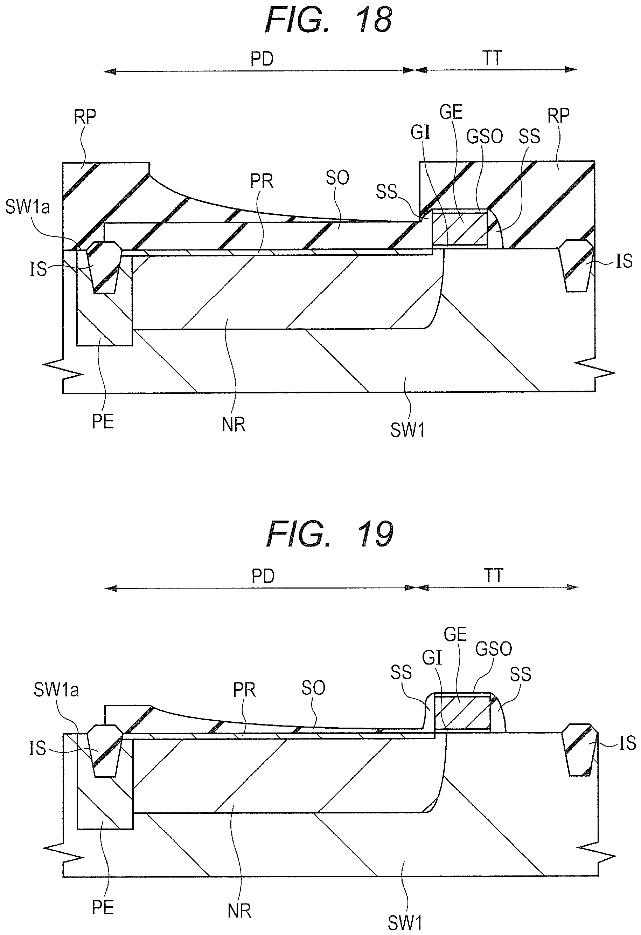

Consequently, as shown in Fig. 18, a three-dimensional resist pattern RP whose thickness gradually decreases toward the gate electrode GE of the transfer transistor TT is made in the photodiode PD formation region.

Next, as shown in Fig. 19, the isolation insulating film SO is processed by anisotropic etching or wet etching using a resist pattern RP as a mask so that the thickness of the isolation insulating film SO gradually decreases toward the gate electrode GE of the transfer transistor TT in the photodiode PD formation region. Then, the resist pattern RP is removed.

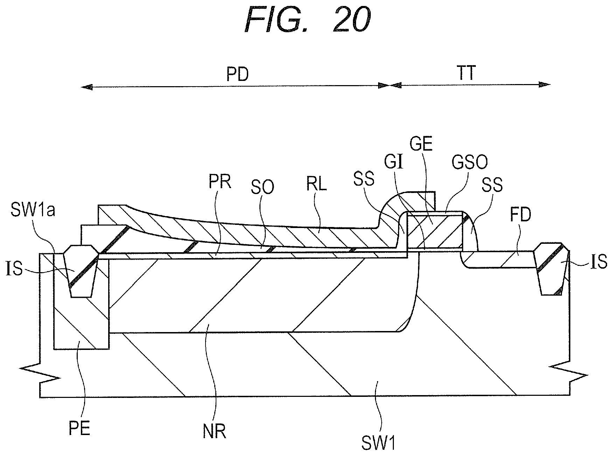

Next, as shown in Fig. 20, a floating diffusion layer FD is formed in the semiconductor substrate SW1 on the other side face side of the gate electrode GE of the transfer transistor TT (opposite to the n-type region NR across a channel region) by implanting n-type impurity ions from the main surface SW1a side of the semiconductor substrate SW1.

Consequently, the n-type region NR which configures the photodiode PD is formed on one side of the semiconductor substrate SW1 and the floating diffusion layer FD is formed on the other side of the semiconductor substrate SW1 with the gate electrode GE of the transfer transistor TT between them.

Next, a reflecting layer RL is formed over the isolation insulating film SO and over the second surface of the gate electrode GE of the transfer transistor TT in a manner to extend from the isolation insulating film SO to the second surface of the gate electrode GE in plan view. At this time, the reflecting layer RL is formed in a manner to cover part of the second surface of the gate electrode GE in plan view. The reflecting layer RL is, for example, made of metal such as tungsten or metal silicide such as cobalt silicide or nickel silicide.

The subsequent steps are the same as in the first embodiment and their description is omitted here.

According to the second embodiment, as a positive potential is applied to the reflecting layer RL, the positive potential is applied to a wide area of the photodiode PD in the planar direction, but since the thickness of the isolation insulating film SO gradually decreases toward the gate electrode GE of the transfer transistor TT, the potential applied to the n-type region NR gradually increases, thereby producing a gradient of potential. Consequently, the CMOS image sensor according to the second embodiment is less likely to fail to capture the charge and provides higher transfer efficiency than the CMOS image sensor according to the first embodiment.

### Third Embodiment

### «Structure of the pixel section of the CMOS transistor»

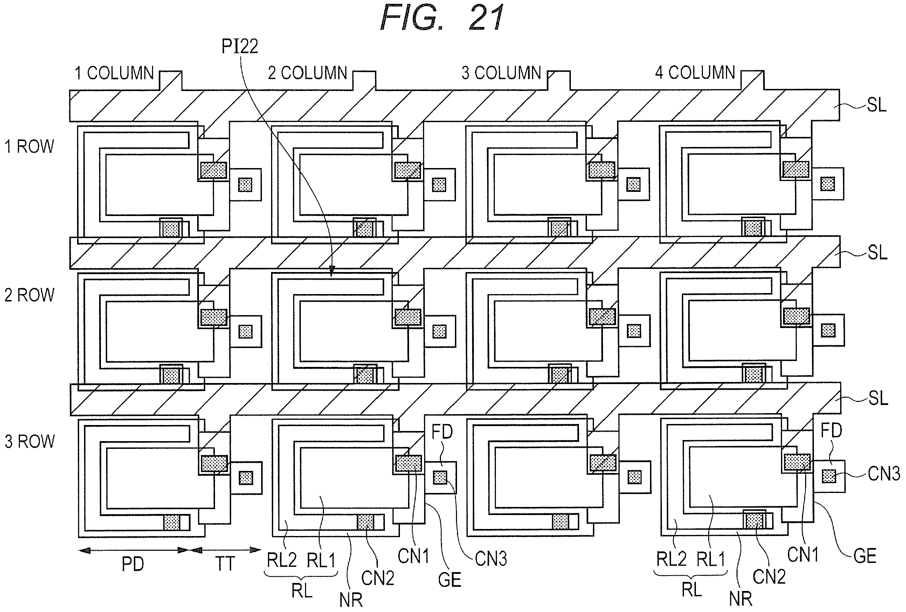

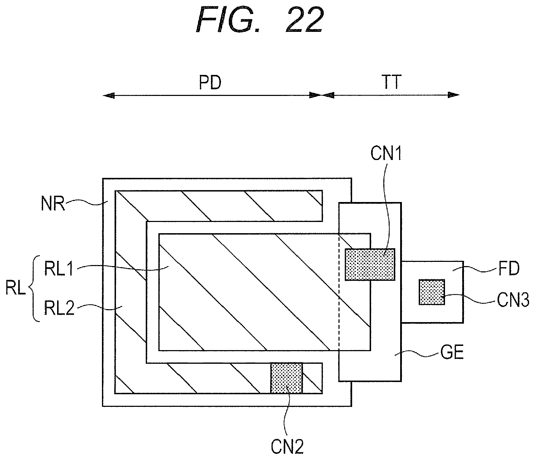

The structure of the pixel section of the back-surface irradiation CMOS image sensor according to the third embodiment will be described referring to Figs. 21 and 22. Fig. 21 is a plan view of a main part of the pixel section of the CMOS image sensor according to the third embodiment. Fig. 22 is a plan view of a main part of a pixel which configures the pixel section of the CMOS image sensor according to the third embodiment.

As shown in Fig. 21, in the pixel section of the CMOS image sensor according to third embodiment, a plurality of pixels are arranged in rows and columns. Fig. 21 shows twelve pixels arranged in three rows and four columns in the pixel section of the CMOS image sensor.

The signal charge accumulated in the photodiode PD is transferred to column signal lines (not shown) as second or higher layer signal wirings on the basis of each row signal line (selected pixel line) SL as a first layer signal wiring, by turning on or off the transfer transistor TT which functions as a pixel selection switch.

Furthermore, as shown in Figs. 21 and 22, in a pixel which configures the pixel section of the CMOS image sensor according to the third embodiment, the reflecting layer RL is divided into two parts. Specifically, the reflecting layer RL is divided into a first part RL1 and a second part RL2, in which the first part RL1 has a portion lying in the center of the photodiode PD and a portion lying over the second surface of the gate electrode GE of the transfer transistor TT and the second part RL2 lies on the periphery of the photodiode PD.

Furthermore, the first part RL1 of the reflecting layer RL is electrically coupled to a row signal line SL over the second surface of the gate electrode GE of the transfer transistor TT through a contact hole CN1 which reaches both the second surface of the gate electrode GE and the first part RL1 of the reflecting layer RL. The second part RL2 of the reflecting layer RL is electrically coupled to a row signal line SL next to the row signal line SL electrically coupled to the first part RL1 of the reflecting layer RL, through a contact hole CN2 which reaches the second part RL2 of the reflecting layer RL. In the figures, CN3 denotes a contact hole which reaches the floating diffusion layer FD.

For example, in pixel PI22, located in the second row and second column, the first part RL1 of the reflecting layer RL is electrically coupled to the row signal line SL in the second row and the second part RL2 of the reflecting layer RL is electrically coupled to the row signal line SL in the third row.

Therefore, when a positive potential is applied to a selected row signal line SL, a negative potential is applied to the non-selected row signal line SL next to the selected row signal line SL and thus different potentials are applied to the first part RL1 of the reflecting layer RL and the second part RL2 of the reflecting layer RL.

Specifically, in transferring the charge (reading a pixel), a positive potential is applied to the gate electrode GE of the transfer transistor TT and the first part RL1 of the reflecting layer RL which are coupled to the selected signal wiring SL. On the other hand, a negative potential is applied to the second part RL2 of the reflecting layer RL which is coupled to the non-selected signal wiring SL next to the selected signal wiring SL. This makes it possible to produce a sharp potential difference in one photodiode PD, so the CMOS image sensor according to the third embodiment provides higher transfer efficiency than the CMOS image sensor according to the first embodiment.

The method for manufacturing the back-surface irradiation CMOS image sensor according to the third embodiment is different from the method for manufacturing the back-surface irradiation CMOS image sensor according to the first embodiment mainly in the shape of the resist pattern used to form the reflecting layer RL, and the other manufacturing steps are substantially the same as in the method for manufacturing the back-surface irradiation CMOS image sensor according to the first embodiment.

Therefore, according to the third embodiment, the reflecting layer RL is divided into two parts, that is, the first part RL1 in the center and the second part RL2 in the peripheral area and they are coupled to different row signal lines SL adjacent to each other so that different potentials are applied to the first part RL1 and second part RL2 of the reflecting layer RL. This makes it possible to produce a sharp potential difference in one photodiode PD and the CMOS image sensor according to the third embodiment is less likely to fail to capture the charge and provides higher transfer efficiency than the CMOS image sensor according to the first embodiment.

The invention made by the present inventors has been so far explained concretely in reference to the preferred embodiments thereof. However, the invention is not limited thereto and it is obvious that these details may be modified in various ways without departing from the gist thereof.

## Claims

1. A semiconductor device comprising:
a first substrate of first conductivity type having a main surface and a back surface opposite to the main surface;
a transfer transistor formed on the main surface side of the first substrate;
a photodiode formed adjacent to the transfer transistor on the main surface side of the first substrate;
an interlayer insulating film formed in a manner to cover the transfer transistor and the photodiode;
a plurality of layers of wirings formed over the interlayer insulating film;
a protective insulating film formed in a manner to cover an uppermost layer of wiring among the layers of wirings;
a second substrate joined to the protective insulating film; and
a lens made on the back surface side of the first substrate,
the transfer transistor comprising:
a gate insulating film formed on the main surface of the first substrate;
a gate electrode formed over the gate insulating film, having a first surface in contact with the gate insulating film and a second surface opposite to the first surface;
a sidewall spacer formed on each of both side faces of the gate electrode;
a first semiconductor region of second conductivity type different from the first conductivity type, provided in the first substrate on one side face side of the gate electrode; and
a second semiconductor region of the second conductivity type, provided in the first substrate on the other side face side of the gate electrode,
the photodiode comprising:
a third semiconductor region of the second conductivity type having a first depth from the main surface of the first substrate and being integrated with the first semiconductor region in the first substrate;
a reflecting layer formed over the third semiconductor region and over the second surface of the gate electrode in a manner to extend from the third semiconductor region to part of the second surface of the gate electrode in plan view; and
an isolation insulating film formed between the third semiconductor region and the reflecting layer,
wherein a first layer wiring is electrically coupled to both the gate electrode and the reflecting layer through a contact hole made in the interlayer insulating film over the second surface of the gate electrode and the same potential is applied to the gate electrode and the reflecting layer.

2. The semiconductor device according to Claim 1, wherein thickness of the isolation insulating film is not less than 50 nm and not more than 200 nm.

3. The semiconductor device according to Claim 1, wherein thickness of the isolation insulating film decreases toward the gate electrode.

4. The semiconductor device according to Claim 1,
wherein the reflecting layer is divided into two parts, or a first part and a second part in plan view,
wherein the first part extends from a center of the third semiconductor region to part of the second surface of the gate electrode in plan view,
wherein the second part lies spaced from the first part on a periphery of the third semiconductor region in plan view, and
wherein different potentials are applied to the first part and the second part and the same potential is applied to the gate electrode and the first part.

5. The semiconductor device according to Claim 1, wherein the reflecting layer is made of tungsten, cobalt silicide, or nickel silicide.

6. The semiconductor device according to Claim 1, wherein a cap insulating film with a thickness of not less than 10 nm and not more than 20 nm is formed between the reflecting layer and the second surface of the gate electrode.

7. The semiconductor device according to Claim 1,
wherein a fourth semiconductor region of the first conductivity type having a second depth smaller than the first depth from the main surface of the first substrate is formed in the third semiconductor region, and
wherein an impurity concentration of the fourth semiconductor region is higher than the impurity concentration of the third semiconductor region.

8. A semiconductor device manufacturing method, comprising the steps of:
(a) forming a first semiconductor region having a first depth from a main surface of a first substrate of first conductivity type, in the first substrate, the first semiconductor region being of second conductivity type different from the first conductivity type;
(b) sequentially forming a first insulating film, a conductor film, and a second insulating film over the main surface of the first substrate, then processing the first insulating film, the conductor film, and the second insulating film to form a gate insulating film from the first insulating film over the main surface of the first substrate, forming a gate electrode from the conductor film so that the gate electrode has a first surface in contact with the gate insulating film and a second surface opposite to the first surface and the first semiconductor region is located on one side face side of the gate electrode, and forming a cap insulating film from the second insulating film over the second surface of the gate electrode;
(c) depositing a third insulating film on the main surface side of the first substrate, then processing the third insulating film to form a sidewall spacer on each of both side faces of the gate electrode, and forming an isolation insulating film over the first semiconductor region;
(d) forming a second semiconductor region of the second conductivity type having a second depth smaller than the first depth from the main surface of the first substrate, in the first substrate on an opposite side of the first semiconductor region across the gate electrode;
(e) depositing a metal film or metal silicide film on the main surface side of the first substrate and then processing the metal film or the metal silicide film to form a reflecting layer over the isolation insulating film and over the second surface of the gate electrode in a manner to extend from the isolating insulating film to part of the second surface of the gate electrode in plan view;
(f) depositing a fourth insulating film on the main surface side of the first substrate, and then processing the fourth insulating film to make a contact hole over the second surface of the gate electrode so as to reach both the second surface of the gate electrode and the reflecting layer; and
(g) forming a first layer wiring to be electrically coupled to the gate electrode and the reflecting layer through the contact hole.

9. The semiconductor device manufacturing method according to Claim 8, the step (c) comprising the steps of:
(c1) forming a resist film over the third insulating film;
(c2) exposing and developing the resist film using a photomask to make a resist pattern; and
(c3) processing the third insulating film using the resist pattern as a mask,
wherein at the step (c2), the resist pattern whose thickness gradually decreases toward the gate electrode is formed over the isolation insulating film by controlling a quantity of light transmitted through the photomask, and
wherein at the step (c3), the isolation insulating film whose thickness gradually decreases toward the gate electrode is formed by etching using the resist pattern as a mask.

10. The semiconductor device manufacturing method according to Claim 8, wherein
at the step (e),
the reflecting layer is divided into two parts, or a first part and a second part, in plan view,
the first part extends from a center of the first semiconductor region to part of the second surface of the gate electrode in plan view, and
the second part lies spaced from the first part on a periphery of the first semiconductor region in plan view.

11. The semiconductor device manufacturing method according to Claim 8, wherein thickness of the isolation insulating film is not less than 50 nm and not more than 200 nm.

12. The semiconductor device manufacturing method according to Claim 8, wherein the reflecting layer is made of tungsten, cobalt silicide, or nickel silicide.

13. The semiconductor device manufacturing method according to Claim 8, wherein thickness of the cap insulating film is not less than 10 nm and not more than 20 nm.

14. The semiconductor device manufacturing method according to Claim 8, further comprising, between the step (b) and the step (c), the step of:
(h) forming a third semiconductor region of the first conductivity type having a third depth smaller than the first depth from the main surface of the first substrate, in the first semiconductor region,
wherein an impurity concentration of the third semiconductor region is higher than the impurity concentration of the first semiconductor region.

15. The semiconductor device manufacturing method according to Claim 8, further comprising, after the step (g), the steps of:
(i) forming a higher layer wiring than the first layer wiring;
(j) forming a protective insulating film to cover an uppermost layer wiring;
(k) attaching a surface of the protective insulating film to a second substrate and then grinding a back surface of the first substrate, opposite to the main surface of the first substrate, to decrease thickness of the first substrate;
(1) forming an antireflection film on the back surface of the first substrate; and
(m) making a color filter over the antireflection film and making a lens over the color filter.
